(19) Europäisches Patentamt
European Patent Office
Office européen des brevets

(11) **EP 3 751 714 B1**

(12) **EUROPÄISCHE PATENTSCHRIFT**

(45) Veröffentlichungstag und Bekanntmachung des Hinweises auf die Patenterteilung:
**26.04.2023   Patentblatt 2023/17**

(21) Anmeldenummer: **19179404.9**

(22) Anmeldetag: **11.06.2019**

(51) Internationale Patentklassifikation (IPC):
*H02M 1/08* *(2006.01)*    *H02M 1/32* *(2007.01)*
*H02M 7/5387* *(2007.01)*    *H03K 17/18* *(2006.01)*
*H03K 17/06* *(2006.01)*

(52) Gemeinsame Patentklassifikation (CPC):
**H02M 1/08; H02M 1/32; H02M 7/53876;**
**H03K 17/06;** H03K 2217/0081

(54) **VERFAHREN ZUM ANSTEUERN EINER UMRICHTERANORDNUNG**

METHOD FOR CONTROLLING A CONVERTER ASSEMBLY

PROCÉDÉ DE COMMANDE D'UN DISPOSITIF CONVERTISSEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**16.12.2020   Patentblatt 2020/51**

(73) Patentinhaber: **Siemens Energy Global GmbH & Co. KG**
**81739 München (DE)**

(72) Erfinder:
• **Alvarez Valenzuela, Rodrigo Alonso**
**90408 Nürnberg (DE)**
• **Roman Marcos, Diego Alberto**
**91052 Erlangen (DE)**
• **Schuster, Dominik**
**91456 Diespeck (DE)**

(56) Entgegenhaltungen:
WO-A2-2012/156261    GB-A- 2 426 395
US-A1- 2016 018 446    US-B1- 8 692 587

**Beschreibung**

Die Erfindung bezieht sich auf Verfahren zum Ansteuern von Umrichteranordnungen, Umrichteranordnungen als solche sowie Steuermodule für Ansteuerschaltungen für Umrichteranordnungen.

Umrichteranordnungen mit Reihenschaltungen mit mindestens zwei in Reihe geschalteten Teilmodulen sowie Verfahren zum Ansteuern solcher Umrichteranordnungen sind beispielsweise aus der internationalen Patentanmeldung WO2012/156261A2 und der Druckschrift "An Innovative Modular Multilevel Converter Topology Suitable for Wide Power Range" (A. Lesnicar und R. Marquardt, 2003 IEEE Bologna Power Tech Conference, 23.-26. Juni 2003, Bologna, Italien) bekannt. Eine Ansteuerung der Umrichteranordnungen erfolgt durch ein Ein- oder Ausschalten von Schaltern der Teilmodule.

Aus der US 2016/018446 A1 ist ein Ansteuerverfahren für einen Umrichter bekannt, bei dem im Falle eines Unterspannungsfehlers eine Schutzmaßnahme eingeleitet wird.

Der Erfindung liegt die Aufgabe zugrunde, ein gegenüber herkömmlichen Ansteuerverfahren verbessertes Ansteuerverfahren für Umrichteranordnungen anzugeben.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass bei zumindest einem der Teilmodule eine Begrenzung der Schaltvorgänge dahingehend erfolgt, dass zumindest eine diesem Teilmodul zugeordnete Ansteuerschaltung nicht über ein vorgegebenes Maß hinaus belastet wird.

Ein wesentlicher Vorteil des erfindungsgemäßen Verfahrens besteht darin, dass durch die vorgeschlagene Begrenzung der Schaltvorgänge eine Überlastung und ggf. ein Ausfall von Ansteuerschaltungen vermieden werden kann.

Vorteilhaft ist es, wenn die Ansteuerschaltung mindestens einem der Schalter des jeweiligen Teilmoduls zugeordnet ist und eine Begrenzung der Schaltvorgänge des mindestens einen zugeordneten Schalters dahingehend erfolgt, dass ein Energiespeicher der Ansteuerschaltung im Rahmen der Ansteuerung dieses Schalters nicht über ein vorgegebenes Maß hinaus entladen wird.

Bei einer vorteilhaften Ausgestaltung des Verfahrens ist vorgesehen, dass die Ansteuerschaltung allen Schaltern des jeweiligen Teilmoduls zugeordnet ist. Bei einer anderen vorteilhaften Ausgestaltung des Verfahrens ist vorgesehen, dass jedem Schalter des Teilmoduls jeweils eine eigene Ansteuerschaltung zugeordnet ist.

Vorzugsweise erfolgt eine Begrenzung der Schaltvorgänge der jeweiligen Ansteuerschaltung dahingehend, dass die Energie eines Energiespeichers der Ansteuerschaltung stets eine vorgegebene Mindestenergiemenge aufweist oder überschreitet.

Für jede Ansteuerschaltung oder für jeden von der Ansteuerschaltung angesteuerten Schalter wird jeweils eine Kontrollvariable geführt.

Die Kontrollvariable wird bei jedem Ein- und/oder Ausschaltvorgang des oder der Schalter jeweils um einen Zuschlagswert betragsmäßig erhöht, der zu dem für das Ein- und/oder Ausschalten des jeweiligen Schalters nötigen Energie- und/oder Ladungsverbrauch der Ansteuerschaltung proportional ist.

Zwischen aufeinanderfolgenden Ein- und/oder Ausschaltvorgängen wird die Kontrollvariable betragsmäßig reduziert.

Die Reduktion erfolgt proportional zur Ladegeschwindigkeit, mit der ein Energiespeicher der Ansteuerschaltung zwischen Umschaltvorgängen des oder der Schalter aufgeladen wird.

Die Ansteuerschaltung und damit ein Ein- und/oder Ausschalten des oder der zugeordneten Schalter wird blockiert, wenn die Kontrollvariable betragsmäßig einen vorgegebenen Schwellenwert überschreitet.

Nach einem Überschreiten des Schwellenwerts erfolgt eine Freigabe der Ansteuerschaltung zum Ein- und/oder Ausschalten eines oder mehrerer der zugeordneten Schalter erst dann wieder, wenn die Kontrollvariable den Schwellenwert oder einen zur Bildung eines Hystereseverhaltens gegenüber dem Schwellenwert kleineren Schwellenwert wieder unterschreitet.

Vorteilhaft ist es, wenn bei allen Teilmodulen der mindestens einen Reihenschaltung oder allen Teilmodulen der Umrichteranordnung insgesamt eine Begrenzung der Schaltvorgänge jeweils dahingehend erfolgt, dass die den Teilmodulen zugeordnete Ansteuerschaltung oder Ansteuerschaltungen nicht über ein vorgegebenes Maß hinaus belastet werden.

Insbesondere ist es von Vorteil, wenn bei allen Schaltern aller Teilmodule der mindestens einen Reihenschaltung oder der Umrichteranordnung insgesamt eine Begrenzung der Schaltvorgänge jeweils dahingehend erfolgt, dass die den Schaltern zugeordneten Ansteuerschaltungen jeweils nicht über ein vorgegebenes Maß hinaus belastet werden.

Die Erfindung bezieht sich darüber hinaus auf ein Steuermodul für eine Ansteuerschaltung, die zum Ein- und Ausschalten von Schaltern eines Teilmoduls einer Umrichteranordnung ausgebildet ist. Erfindungsgemäß ist bezüglich des Steuermoduls vorgesehen, dass dieses derart ausgestaltet ist, dass es eine Begrenzung der Schaltvorgänge der Ansteuereinrichtung dahingehend durchführt, dass diese nicht über ein vorgegebenes Maß hinaus belastet wird. Bezüglich der Vorteile des erfindungsgemäßen Steuermoduls sei auf die obigen Ausführungen im Zusammenhang mit dem erfindungsgemäßen Verfahren verwiesen.

Erfindungsgemäß ist das Steuermodul derart ausgebildet, dass es für die zugeordnete Ansteuerschaltung jeweils eine Kontrollvariable führt, wobei es die Kontrollvariable bei jedem Ein- und/oder Ausschaltvorgang des oder der zugeordneten Schalter jeweils um einen Zuschlagswert erhöht, der zu dem für das Ein- und/oder Ausschalten des oder der Schalter nötigen Ladungs- und/oder Energieverbrauch der Ansteuerschaltung proportional ist, und zwischen aufeinanderfolgenden Einschaltvorgängen die Kontrollvariable reduziert.

Die Reduktion erfolgt proportional zur Ladegeschwindigkeit, mit der ein Energiespeicher der Ansteuerschaltung zwischen Umschaltvorgängen aufgeladen wird.

Das Steuermodul ist derart ausgebildet, dass es die Ansteuerschaltung und damit ein Ein- und/oder Ausschalten des oder der zugeordneten Schalter blockiert, wenn die Kontrollvariable einen vorgegebenen Schwellenwert überschreitet, und nach einem Überschreiten des Schwellenwerts eine Freigabe der Ansteuerschaltung zum Ein- und/oder Ausschalten eines oder mehrerer der zugeordneten Schalter erst wieder erteilt, wenn die Kontrollvariable den Schwellenwert wieder unterschreitet oder einen zur Bildung eines Hystereseverhaltens gegenüber dem Schwellenwert kleineren Schwellenwert wieder unterschreitet.

Die Erfindung bezieht sich darüber hinaus auf eine Umrichteranordnung, die mindestens eine Reihenschaltung umfasst, wobei die mindestens eine Reihenschaltung mindestens zwei in Reihe geschaltete Teilmodule aufweist, die jeweils mindestens zwei Schalter und einen Kondensator umfassen, und wobei bei der Umrichteranordnung während ihres Betriebs ein Umschalten eines oder mehrerer der Teilmodule erfolgt.

Erfindungsgemäß ist bezüglich der Umrichteranordnung vorgesehen, dass zumindest eines der Teilmodule, vorzugsweise alle Teilmodule, jeweils mit zumindest einem Steuermodul wie oben beschrieben ausgestattet ist. Bezüglich der Vorteile des erfindungsgemäßen Steuermoduls sei auf die obigen Ausführungen im Zusammenhang mit dem erfindungsgemäßen Verfahren verwiesen.

Die Erfindung wird nachfolgend näher erläutert, dabei zeigen beispielhaft:

Figur 1    ein Beispiel für eine erfindungsgemäße Umrichteranordnung, an der beispielhaft ein Beispiel für ein erfindungsgemäßes Verfahren erläutert wird, und

Figur 2    ein Beispiel für den zeitlichen Verlauf einer Kontrollvariable, die von einem Steuermodul der Umrichteranordnung gemäß Figur 1 zum Zwecke der Ansteuerung eines Teilmoduls geführt wird.

In den Figuren werden der Übersicht halber für identische oder vergleichbaren Komponenten stets dieselben Bezugszeichen verwendet.

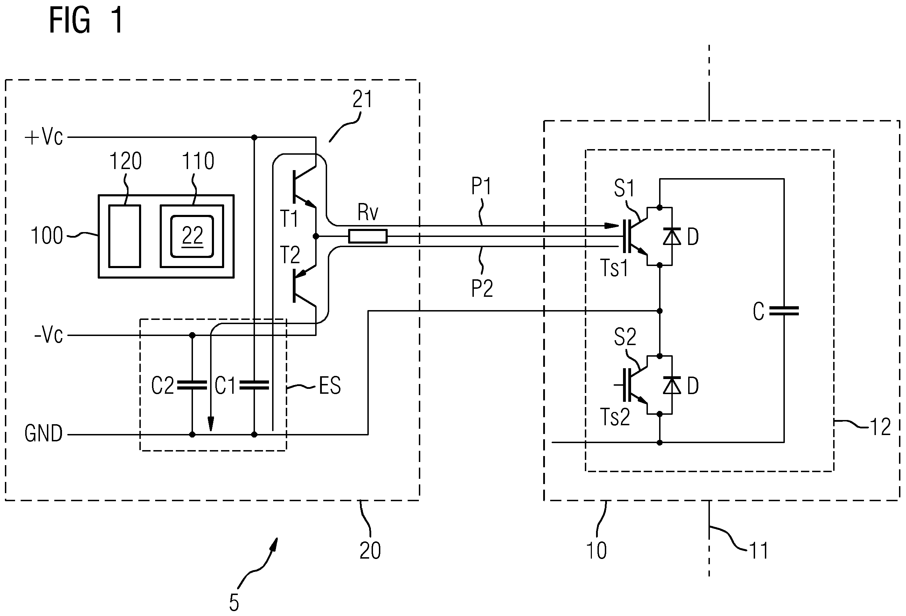

Figur 1 zeigt eine Umrichteranordnung 5 mit einem Umrichter 10. Der Umrichter 10 ist mit mindestens einer Reihenschaltung 11 ausgestattet, die eine Vielzahl an in Reihe geschalteten Teilmodulen 12 aufweist. Aus Gründen der Übersicht ist in der Figur 1 lediglich eines der Teilmodule 12 der Reihenschaltung 11 dargestellt. Die nachfolgenden Ausführungen anhand des Teilmoduls 12 gelten für die anderen nicht gezeigten Teilmodule 12 der Reihenschaltung 11 entsprechend. Bei dem Umrichter 10 kann es sich beispielsweise um einen Umrichter handeln, wie er in den eingangs genannten Literaturstellen eingehend beschrieben ist.

Das Teilmodul 12 gemäß Figur 1 weist eine Halbbrückenschaltung mit zwei Schaltern S1 und S2 und einem parallel geschalteten Kondensator C auf. Die beiden Schalter S1 und S2 werden jeweils durch einen Transistor Ts1 bzw. Ts2 sowie eine dazu parallel geschaltete Freilaufdiode D gebildet.

Anstelle einer Halbbrückenschaltung können die Teilmodule 12 der Reihenschaltung 11 auch jeweils mit einer Vollbrückenschaltung ausgestattet sein, bei der vier Schalter anstelle von nur zwei Schaltern vorhanden sind; die Ausführungen im Zusammenhang mit der in der Figur 1 gezeigten Halbbrückenschaltung gelten für eine alternative Ausgestaltung der Teilmodule 12 als Vollbrückenschaltung entsprechend.

Zur Ansteuerung des in der Figur 1 oberen Schalters S1 des Teilmoduls 12 ist eine Ansteuerschaltung 21 einer Ansteuereinrichtung 20 vorgesehen. Die Ansteuerschaltung 21 umfasst einen Ladetransistor T1, einen positiv aufgeladenen Ladekondensator C1, einen Entladetransistor T2, einen negativ aufgeladenen Entladekondensator C2 und einen Vorwiderstand Rv. Die Kapazitätswerte des Ladekondensators C1 und des Entladekondensators C2 sind vorzugsweise gleich groß.

Der Ladekondensator C1 steht mit einem positiven Potenzial +Vc in Verbindung und wird somit mit einer positiven Spannung aufgeladen; der Entladekondensator C2 ist mit einem negativen Potenzial -Vc beaufschlagt und wird somit mit einer negativen Spannung geladen. Die beiden Spannungspotenziale +Vc und -Vc beziehen sich beispielsweise auf ein Massepotenzial GND der Ansteuerschaltung 21.

Soll der in der Figur 1 obere Schalter S1 des Teilmoduls 12 eingeschaltet werden, so wird der Ladetransistor T1 eingeschaltet, wodurch es zu einem Ladestrom (siehe Pfeil P1) ausgehend vom Ladekondensator C1 durch den Ladetransistor T1 und den Vorwiderstand Rv hindurch zum Transistor Ts1 des Schalters S1 kommt. Der Ladestrom lädt eine eingangsseitige Kapazität des Transistors Ts1, beispielsweise eine Basis-Emitter-Kapazität im Falle eines bipolaren Transistors oder eine Gate-Source-Kapazität im Falle eines Feldeffekttransistors, auf, wodurch es zu einem Einschalten des Transistors Ts1 bzw. des Schalters S1 kommt. Der Einschaltvorgang führt zu einem Entladen des Ladekondensators C1, da der Ladestrom dem Ladekondensator C1 entnommen wird. Während des Einschaltens des Schalters S1 ist der Entladetransistor T2 der Ansteuerschaltung 21 ausgeschaltet.

Soll der Schalter S1 ausgeschaltet werden, so wird bei abgeschaltetem Ladetransistor T1 der Entladetransistor T2 eingeschaltet, wodurch es zu einem Entladestrom über den negativ aufgeladenen Entladekondensator C2 kommt.

Das Ein- und Ausschalten der Transistoren T1 und T2 bzw. das Umschalten des Schalters S1 wird von einem Steuermodul 22 der Ansteuereinrichtung 20 gesteuert, dass die beiden Transistoren T1 und T2 der Ansteuerschaltung 21 kontrolliert bzw. ansteuert. Das Steuermodul 22 kann als Softwaremodul ausgestaltet und in einem Speicher 110 einer Steuereinrichtung 100 der Ansteuereinrichtung 20 abgespeichert sein. Führt eine Recheneinrichtung 120 der Steuereinrichtung 100 das Steuermodul 22 aus, so erfolgt ein Ein- und Ausschalten des Schalters S1, wie es oben erläutert wurde.

Wie sich den obigen Erläuterungen entnehmen lässt, wird der Ladekondensator C1 bei jedem Einschaltvorgang belastet bzw. entladen, weil er über den Ladetransistor T1 und den Vorwiderstand Rv die Eingangskapazität des Transistors Ts des Schalter S1 aufladen muss. In entsprechender Weise wird der Entladekondensator C2 belastet, wenn er zum Ausschalten des Schalters S1 über den Entladetransistor T2 und den Vorwiderstand Rv die Eingangskapazität des Transistors Ts1 des Schalters S1 wieder entladen muss. Jedes Einschalten und jedes Ausschalten des Schalters S1 belastet somit den Energiespeicher ES, der durch den Ladekondensator C1 und den Entladekondensator C2 der Ansteuerschaltung 21 gebildet wird.

Um eine Überlastung der Ansteuerschaltung 21 bzw. ein zu starkes Entladen des Energiespeichers ES bzw. der beiden Kondensatoren C1 und C2 zu vermeiden, ist das Steuermodul 22 der Ansteuereinrichtung 20 derart ausgestaltet, dass es die Umschaltvorgänge überwacht und ggf. blockiert.

Zu diesem Zweck führt das Steuermodul 22 vorzugsweise eine Kontrollvariable KV, die sie bei jedem Einschaltvorgang und jedem Ausschaltvorgang des Schalters S1 betragsmäßig erhöht, und zwar jeweils um einen Zuschlagswert ZW. Der Zuschlagswert ZW ist derart bemessen, dass er dem für das Einschalten des Schalters S1 bzw. das Ausschalten des Schalters S2 nötigen Energieverbrauch der Ansteuerschaltung 21, also dem Ladungsverbrauch des Ladekondensators C1 beim Laden und dem Ladungsverbrauch des Entladekondensators C2 beim Ausschalten des Schalters S1, entspricht oder proportional dazu ist.

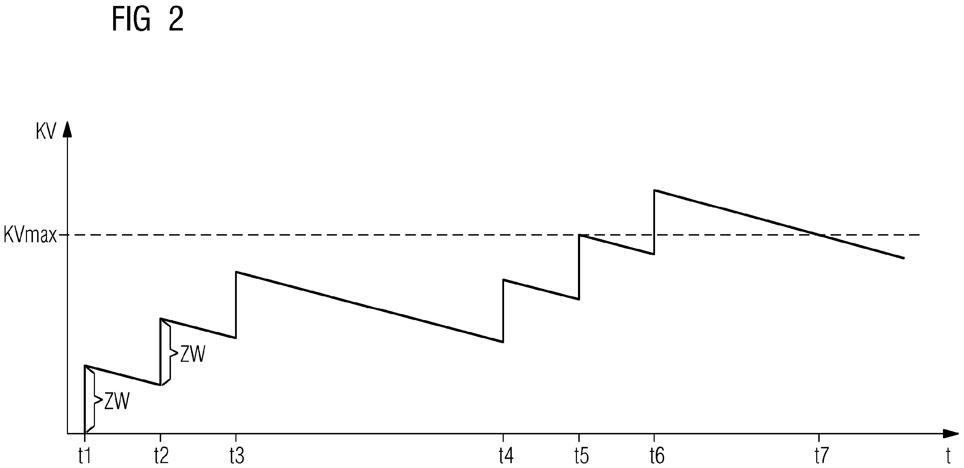

Die Figur 2 zeigt einen beispielhaften zeitlichen Verlauf der Kontrollvariable KV über der Zeit t. Es lässt sich erkennen, dass ausgehend von einem Wert der Kontrollvariable KV = 0 bei einem Einschaltvorgang zum Zeitpunkt t1 die Kontrollvariable KV um den Zuschlagswert ZW erhöht wird, der dem Ladungsverbrauch des Ladekondensators C1 in Figur 1 bzw. dem Energieverbrauch der Ansteuerschaltung 21 zum Einschalten des Schalters S1 entspricht.

Nach dem erfolgten Einschalten des Schalters S1 bzw. dem Aufladen der Eingangskapazität des Transistors Ts des Schalters S1 kann der Ladekondensator C1 über das Potenzial +Vc wieder aufgeladen werden, sodass der Energieverlust bzw. der Ladungsverlust des Ladekondensators C1 wieder kompensiert wird. Aus diesem Grund wird die Kontrollvariable KV danach über der Zeit reduziert, beispielsweise wie in der Figur 2 gezeigt, linear. Die lineare Reduktion kann proportional zur Zeit t und proportional zu einem Ladegeschwindigkeitswert sein, der die Ladegeschwindigkeit zum Aufladen des Energiespeichers ES angibt. Im Falle eines konstanten Ladestroms kann der Ladegeschwindigkeitswert beispielsweise die Ladestromstärke angeben.

Zu einem Zeitpunkt t2 erfolgt ein Ausschalten des Schalters S1, wodurch der Entladekondensator C2 belastet bzw. entladen wird; demgemäß wird die Kontrollvariable KV wiederum um den Zuschlagswert ZW erhöht. Bei dem Beispiel gemäß Figur 2 wird davon ausgegangen, dass der Energieverbrauch beim Einschalten genau so groß ist wie der Energieverbrauch beim Ausschalten des Schalters S1.

In der Zeitspanne zwischen den Zeitpunkten t2 und t3 in Figur 2 erfolgt wieder ein Aufladen des Energiespeichers ES, was wiederum durch eine entsprechende Reduktion der Kontrollvariable KV über der Zeit berücksichtigt wird.

Bei dem Beispiel gemäß Figur 2 erfolgt die Reduktion der Kontrollvariable KV - wie bereits erwähnt - über der Zeit linear. Alternativ kann eine andere Art der Reduktion vorgenommen werden, beispielsweise eine exponentielle oder polynomielle Reduktion über der Zeit t. Eine exponentielle Reduktion ist beispielsweise vorteilhaft, wenn das Laden des Ladekondensators C1 und des Entladekondensators C2 nicht mit einem konstanten Ladestrom (wie beim Beispiel gemäß der Figur 2) erfolgt, sondern beispielsweise mit einer konstanten Ladespannung über einen nicht gezeigten Ladevorwiderstand; in einem solchen Falle reduziert sich der Ladestrom über der Zeit mit dem Anwachsen des Ladezustands.

Sobald die Kontrollvariable KV einen Schwellenwert KVmax erreicht (siehe Zeitpunkt t6), wird das Steuermodul 22 die Ansteuerschaltung 21 blockieren bzw. ein weiteres Umschalten der beiden Transistoren T1 und T2 verhindern bzw. nicht vornehmen. Auf diese Weise wird erreicht, dass der Energiespeicher ES wieder ausreichend mit Energie geladen wird und die beiden Kondensatoren C1 und C2 einen ausreichenden Ladezustand erreichen, bevor es zu weiteren Schalthandlungen kommt.

Erst wenn der Schwellenwert KVmax wieder unterschritten wird, beispielsweise unter Berücksichtigung einer Hysterese, wird die Ansteuerschaltung 21 bzw. die Ansteuerung des Schalters S1 wieder freigegeben.

Die Blockadezeit (hier die Zeitdifferenz t7-t6 zwischen den Zeitpunkten t6 und t7), zu der die Ansteuerschaltung 21 deaktiviert ist, ist also nicht konstant bzw. kein fester Wert, sondern wird durch den Ladezustand des Energiespeichers ES bestimmt, dessen Ladezustand wiederum in einfacher Weise durch die Kontrollvariable KV beschrieben wird. Nur dann, wenn die Kontrollvariable KV eine zu starke Beanspruchung des Energiespeichers ES anzeigt, kommt es zu einem Blockieren des Schaltzustands des Schalters S1; falls dies nicht der Fall ist, kann der Schalter S1 je nach den Anforderungen der Umrichteranordnung 10 ein- oder ausgeschaltet werden.

Der Schwellenwert KVmax ist vorzugsweise proportional zu einem Energiewert ΔE gemäß:

$$\Delta E = 0{,}5 * C * (U_{nom}^2 - U_{min}^2)$$

wobei C die Kapazität der beiden Kondensatoren C1 und C2, Unom die nominelle Arbeitsspannung der beiden Kondensatoren C1 und C2 und Umin eine vorgegebene Minimalspannung der beiden Kondensatoren C1 und C2 bezeichnet.

Bezugszeichenliste

| | |
|---|---|
| 5 | Umrichteranordnung |
| 10 | Umrichter |
| 11 | Reihenschaltung |
| 12 | Teilmodul |
| 20 | Ansteuereinrichtung |
| 21 | Ansteuerschaltung |
| 22 | Steuermodul |
| 100 | Steuereinrichtung |
| 110 | Speicher |
| 120 | Recheneinrichtung |
| C | Kondensator |
| C1 | Ladekondensator |
| C2 | Entladekondensator |
| D | Freilaufdiode |
| ES | Energiespeicher |
| GND | Massepotenzial |
| KV | Kontrollvariable |
| KVmax | Schwellenwert |
| P1 | Pfeil |
| Rv | Vorwiderstand |
| S1 | Schalter |
| S2 | Schalter |
| t | Zeit |
| t1-t7 | Zeitpunkt |
| T1 | Ladetransistor |
| T2 | Entladetransistor |
| Ts1 | Transistor |
| Ts2 | Transistor |
| +Vc | Spannungspotenzial |
| -Vc | Spannungspotenzial |
| ZW | Zuschlagswert |

Patentansprüche

1. Verfahren zum Ansteuern einer Umrichteranordnung (5), die mindestens eine Reihenschaltung (11) umfasst,

- wobei bei dem Verfahren eine Ansteuerung der Umrichteranordnung (5) ein Umschalten eines oder mehrerer der Teilmodule (12) und ein Ein- oder Ausschalten von zumindest einem der Schalter (S1, S2) der umzuschaltenden Teilmodule (12) ermöglicht,
bei zumindest einem der Teilmodule (12) eine Begrenzung der Schaltvorgänge dahingehend erfolgt, dass zumindest eine diesem Teilmodul (12) zugeordnete Ansteuerschaltung (21) nicht über ein vorgegebenes Maß hinaus belastet wird,
**dadurch gekennzeichnet, dass** die mindestens eine Reihenschaltung (11) mindestens zwei in Reihe geschaltete Teilmodule (12) aufweist, die jeweils mindestens zwei Schalter (S1, S2) und einen Kondensator (C) umfassen, wobei
für jede Ansteuerschaltung (21) oder für jeden von der Ansteuerschaltung (21) angesteuerten Schalter (S1, S2) jeweils eine Kontrollvariable (KV) geführt wird, wobei die Kontrollvariable (KV)
- bei jedem Ein- und/oder Ausschaltvorgang des oder der Schalter (S1, S2) jeweils um einen Zuschlagswert (ZW) betragsmäßig erhöht wird, der zu dem für das Ein- und/oder Ausschalten des jeweiligen Schalters (S1, S2) nötigen Energie- und/oder Ladungsverbrauch der Ansteuerschaltung (21) proportional ist, und
- zwischen aufeinanderfolgenden Ein- und/oder Ausschaltvorgängen die Kontrollvariable (KV) betragsmäßig reduziert wird, wobei
- die Reduktion proportional zur Ladegeschwindigkeit erfolgt, mit der ein Energiespeicher (ES) der Ansteuerschaltung (21) zwischen Umschaltvorgängen des oder der Schalter (S1, S2) aufgeladen wird,
- die Ansteuerschaltung (21) und damit ein Ein- und/oder Ausschalten des oder der zugeordneten Schalter (S1, S2) blockiert wird, wenn die Kontrollvariable (KV) betragsmäßig einen vorgegebenen Schwellenwert (KVmax) überschreitet, und
- nach einem Überschreiten des Schwellenwerts eine Freigabe der Ansteuerschaltung (21) zum Ein- und/oder Ausschalten eines oder mehrerer der zugeordneten Schalter (S1, S2) erst dann wieder erfolgt, wenn die Kontrollvariable (KV) den Schwellenwert (KVmax) oder einen zur Bildung eines Hystereseverhaltens gegenüber dem Schwellenwert (KVmax) kleineren Schwellenwert wieder unterschreitet.

**2.** Verfahren nach Anspruch 1,
**dadurch gekennzeichnet, dass**
eine Begrenzung der Schaltvorgänge dahingehend erfolgt, dass ein Energiespeicher (ES) der Ansteuerschaltung (21) nicht über ein vorgegebenes Maß hinaus entladen wird.

**3.** Verfahren nach Anspruch 1 oder 2,
**dadurch gekennzeichnet, dass**
eine Begrenzung der Schaltvorgänge dahingehend erfolgt, dass die Energie eines Energiespeichers (ES) der Ansteuerschaltung (21) stets eine vorgegebene Mindestenergiemenge aufweist oder überschreitet.

**4.** Verfahren nach einem der voranstehenden Ansprüche,
**dadurch gekennzeichnet, dass**

    - die Ansteuerschaltung (21) allen Schaltern (S1, S2) des jeweiligen Teilmoduls (12) zugeordnet ist oder
    - jedem Schalter (S1, S2) des Teilmoduls (12) jeweils eine eigene Ansteuerschaltung (21) zugeordnet ist.

**5.** Verfahren nach einem der voranstehenden Ansprüche,
**dadurch gekennzeichnet, dass**
bei allen Teilmodulen (12) der mindestens einen Reihenschaltung (11) oder allen Teilmodulen (12) der Umrichteranordnung (5) insgesamt eine Begrenzung der Schaltvorgänge jeweils dahingehend erfolgt, dass die den Teilmodulen (12) zugeordnete Ansteuerschaltung (21) oder Ansteuerschaltungen nicht über ein vorgegebenes Maß hinaus belastet werden.

**6.** Verfahren nach einem der voranstehenden Ansprüche,
**dadurch gekennzeichnet, dass**
bei allen Schaltern (S1, S2) aller Teilmodule (12) der mindestens einen Reihenschaltung (11) oder der Umrichteranordnung (5) insgesamt eine Begrenzung der Schaltvorgänge jeweils dahingehend erfolgt, dass die den Schalter (S1, S2) zugeordneten Ansteuerschaltungen nicht über ein vorgegebenes Maß hinaus belastet werden.

**7.** Steuermodul (22) für eine Ansteuerschaltung (21), die zum Ein- und Ausschalten von Schaltern (S1, S2) eines Teilmoduls (12) einer Umrichteranordnung (5) ausgebildet ist, und zwar einer solchen Umrichteranordnung (5), die mindestens eine Reihenschaltung (11) mit mindestens zwei in Reihe geschalteten Teilmodule (12) aufweist, die jeweils mindestens zwei Schalter (S1, S2) und einen Kondensator (C) umfassen, wobei das Steuermodul (22) derart ausgestaltet ist, dass es eine Begrenzung der Schaltvorgänge der Ansteuereinrichtung dahingehend durchführt, dass diese nicht über ein vorgegebenes Maß hinaus belastet wird,
**dadurch gekennzeichnet, dass**

    das Steuermodul (22) derart ausgebildet ist, dass es für die zugeordnete Ansteuerschaltung (21) jeweils eine Kontrollvariable (KV) führt, wobei es die Kontrollvariable (KV)

        - bei jedem Ein- und/oder Ausschaltvorgang des oder der zugeordneten Schalter (S1, S2) jeweils um einen Zuschlagswert (ZW) erhöht, der zu dem für das Ein- und/oder Ausschalten des oder der Schalter (S1, S2) nötigen Ladungs- und/oder Energieverbrauch der Ansteuerschaltung (21) proportional ist, und
        - zwischen aufeinanderfolgenden Einschaltvorgängen die Kontrollvariable (KV) reduziert, wobei

    die Reduktion proportional zur Ladegeschwindigkeit erfolgt, mit der ein Energiespeicher (ES) der Ansteuerschaltung (21) zwischen Umschaltvorgängen der Schalter (S1, S2) aufgeladen wird, und wobei
    das Steuermodul (22) derart ausgebildet ist, dass es

        - die Ansteuerschaltung (21) und damit ein Ein- und/oder Ausschalten des oder der zugeordneten Schalter (S1, S2) blockiert, wenn die Kontrollvariable (KV) einen vorgegebenen Schwellenwert (KVmax) überschreitet, und
        - nach einem Überschreiten des Schwellenwerts eine Freigabe der Ansteuerschaltung (21) zum Ein- und/oder Ausschalten eines oder mehrerer der zugeordneten Schalter (S1, S2) erst wieder erteilt, wenn die Kontrollvariable (KV) den Schwellenwert (KVmax) wieder unterschreitet oder einen zur Bildung eines Hystereseverhaltens gegenüber dem Schwellenwert (KVmax) kleineren Schwellenwert wieder unterschreitet.

**8.** Umrichteranordnung (5), die mindestens eine Reihenschaltung (11) umfasst,

    - wobei die mindestens eine Reihenschaltung (11) mindestens zwei in Reihe geschaltete Teilmodule (12) aufweist, die jeweils mindestens zwei Schalter (S1, S2) und einen Kondensator (C) umfassen, und

- wobei bei der Umrichteranordnung (5) während ihres Betriebs ein Umschalten eines oder mehrerer der Teilmodule (12) erfolgt,

**dadurch gekennzeichnet, dass**
zumindest eines der Teilmodule (12), vorzugsweise alle Teilmodule (12), jeweils mit zumindest einem Steuermodul (22) nach Anspruch 7 ausgestattet ist.

**Claims**

1. Method for actuating a converter arrangement (5) that comprises at least one series circuit (11),

   - wherein, in the method, an actuation of the converter arrangement (5) enables a switchover of one or more of the submodules (12) and a switch-on or switch-off of at least one of the switches (S1, S2) of the submodules (12) that are to be switched over,
   for at least one of the submodules (12), the switching operations are limited to the effect that at least one actuation circuit (21) assigned to this submodule (12) is not loaded beyond a predetermined extent,
   **characterized in that**
   the at least one series circuit (11) includes at least two submodules (12) that are connected in series and each comprise at least two switches (S1, S2) and a capacitor (C), wherein
   a respective control variable (KV) is managed for each actuation circuit (21) or for each switch (S1, S2) actuated by the actuation circuit (21), wherein the absolute value of the control variable (KV)
   - is increased, during each switch-on and/or switch-off operation of the switch or switches (S1, S2), in each case by a supplemental value (ZW) that is proportional to the energy consumption and/or charge consumption of the actuation circuit (21) that is/are required for the switch-on and/or switch-off of the respective switch (S1, S2), and
   - the absolute value of the control variable (KV) is reduced between successive switch-on and/or switch-off operations, wherein
   - the reduction is carried out proportionally to the charging speed at which an energy storage unit (ES) of the actuation circuit (21) is charged between switchover operations of the switch or switches (S1, S2),
   - the actuation circuit (21), and therefore a switch-on and/or switch-off of the assigned switch or switches (S1, S2), is blocked if the absolute value of the control variable (KV) exceeds a predetermined threshold value (KVmax), and
   - following the threshold value being exceeded, the actuation circuit (21) is authorized to switch on and/or switch off one or more of the assigned switches (S1, S2) again only when the control variable (KV) again falls below the threshold value (KVmax) or a threshold value that is smaller than the threshold value (KVmax) for forming a hysteresis behaviour.

2. Method according to Claim 1,
   **characterized in that**
   the switching operations are limited to the effect that an energy storage unit (ES) of the actuation circuit (21) is not discharged beyond a predetermined extent.

3. Method according to Claim 1 or 2,
   **characterized in that**
   the switching operations are limited to the effect that the energy of an energy storage unit (ES) of the actuation circuit (21) always has or exceeds a predetermined minimum amount of energy.

4. Method according to one of the preceding claims,
   **characterized in that**

   - the actuation circuit (21) is assigned to all the switches (S1, S2) of the respective submodule (12), or
   - a respective separate actuation circuit (21) is assigned to each switch (S1, S2) of the submodule (12).

5. Method according to one of the preceding claims,
   **characterized in that**,
   for all the submodules (12) of the at least one series circuit (11) or all the submodules (12) of the converter arrangement (5), the switching operations are limited overall in each case to the effect that the actuation circuit (21) or actuation circuits assigned to the submodules (12) are not loaded beyond a predetermined extent.

6. Method according to one of the preceding claims,
   **characterized in that**,
   for all the switches (S1, S2) of all the submodules (12) of the at least one series circuit (11) or of the converter arrangement (5), the switching operations are limited overall in each case to the effect that the actuation circuits assigned to the switches (S1, S2) are not loaded beyond a predetermined extent.

7. Control module (22) for the actuation circuit (21) that is designed to switch on and switch off switches (S1, S2) of a submodule (12) of a converter arrangement (5), specifically such a converter arrangement (5) that has at least one series circuit (11) comprising at least two submodules (12) that are connected in series and each comprise at least two switches (S1, S2) and a capacitor (C), wherein the control module (22) is configured in such a way that it limits the switching operations of the actuation device to the effect that said actuation device is not loaded beyond a predetermined extent, **characterized in that**

the control module (22) is designed in such a way that it manages a respective control variable (KV) for the assigned actuation circuit (21), wherein it

- increases the control variable (KV), during each switch-on and/or switch-off operation of the assigned switch or switches (S1, S2), in each case by a supplemental value (ZW) that is proportional to the charge consumption and/or energy consumption of the actuation circuit (21) that is/are required for the switch-on and/or switch-off of the switch or switches (S1, S2), and
- reduces the control variable (KV) between successive switch-on operations, wherein

the reduction is carried out proportionally to the charging speed at which an energy storage unit (ES) of the actuation circuit (21) is charged between switchover operations of the switches (S1, S2), and wherein the control module (22) is designed in such a way that it

- blocks the actuation circuit (21), and therefore a switch-on and/or switch-off of the assigned switch or switches (S1, S2), if the control variable (KV) exceeds a predetermined threshold value (KVmax), and
- following the threshold value being exceeded, grants authorization for the actuation circuit (21) to switch on and/or switch off one or more of the assigned switches (S1, S2) again only when the control variable (KV) again falls below the threshold value (KVmax) or again falls below a threshold value that is smaller than the threshold value (KVmax) for forming a hysteresis behaviour.

8. Converter arrangement (5), which comprises at least one series circuit (11),

- wherein the at least one series circuit (11) includes at least two submodules (12) that are connected in series and each comprise at least two switches (S1, S2) and a capacitor (C), and
- wherein, in the converter arrangement (5), during operation thereof, there is a switchover of one or more of the submodules (12),

**characterized in that**
at least one of the submodules (12), preferably all the submodules (12), is/are in each case equipped with at least one control module (22) according to Claim 7.


**Revendications**

1. Procédé de commande d'un montage (5) convertisseur, qui comprend au moins un circuit (11) série,

- dans lequel, dans le procédé, une commande du montage (5) convertisseur rend possible une commutation d'un ou de plusieurs des modules (12) partiels et une fermeture ou une ouverture d'au moins l'un des interrupteurs (S1, S2) des modules (12) partiels à commuter,
pour au moins l'un des modules (12) partiels a lieu une limitation des opérations de commutation, en ce que l'on ne charge pas au-delà d'une mesure donnée à l'avance, au moins un circuit (21) de commande associé à ce module (12) partiel,
**caractérisé en ce que**
le au moins un circuit (11) a au moins deux modules (12) partiels montés en série, qui comprennent chacun au moins deux interrupteurs (S1, S2) et un condensateur (C), dans lequel
pour chaque circuit (21) de commande ou pour chaque interrupteur (S1, S2) commandé par le circuit (21) de commande, on règle respectivement une variable (KV) de contrôle, dans lequel
- pour chaque opération de fermeture et/ou d'ouverture du ou des interrupteurs (S1, S2), on augmente en valeur absolue la variable (KV) de contrôle d'une valeur (ZW) d'augmentation, qui est proportionnelle à la consommation d'énergie et/ou de charge du circuit (21) de commande nécessaire à la fermeture et/ou à l'ouverture de l'interrupteur (S1, S2) respectif, et
- on réduit en valeur absolue la variable (KV) de contrôle entre des opérations successives de fermeture et/ou d'ouverture, dans lequel
- la réduction s'effectue proportionnellement à la vitesse de charge à laquelle on charge un accumulateur (ES) d'énergie du circuit (21) de commande, entre des opérations de commutation du ou des interrupteurs (S1, S2),
- on bloque le circuit (21) de commande et ainsi une fermeture et/ou une ouverture du ou des interrupteurs (S1, S2) associés, si la variable (KV) de contrôle dépasse en valeur absolue une valeur (KVmax) de seuil donnée à l'avance, et
- après un dépassement de la valeur de seuil, une validation du circuit (21) de commande, pour la fermeture et/ou l'ouverture d'un ou des plusieurs interrupteurs (S1, S2) associés, n'a

EP 3 751 714 B1

lieu à nouveau que si la variable (KV) de contrôle redevient inférieure à la valeur (KVmax) de seuil ou à une valeur de seuil plus petite que la valeur (KVmax) de seuil, pour la formation d'un comportement hystérésis.

2. Procédé suivant la revendication 1, **caractérisé en ce qu'** une limitation des opérations de commutation a lieu, **en ce que** l'on ne décharge pas au-delà d'une mesure donnée à l'avance un accumulateur (ES) d'énergie du circuit (21) de commande.

3. Procédé suivant la revendication 1 ou 2, **caractérisé en ce qu'** une limitation des opérations de commutation a lieu, **en ce que** l'énergie d'un accumulateur (ES) d'énergie du circuit (21) de commande a toujours une quantité d'énergie minimum donnée à l'avance ou la dépasse.

4. Procédé suivant l'une des revendications précédentes, **caractérisé en ce que**

   - le circuit (21) de commande est associé à tous les interrupteurs (S1, S2) du module (12) partiel respectif, ou
   - respectivement un circuit (21) de commande propre est associé à chaque interrupteur (S1, S2) du module (12) partiel.

5. Procédé suivant l'une des revendications précédentes, **caractérisé en ce que** pour tous les modules (12) partiels du au moins un circuit (11) série ou pour tous les modules (12) partiels du montage (5) convertisseur, a lieu dans l'ensemble une limitation des opérations de coupure respectiveme **en ce que** l'on ne charge pas, au-delà d'une mesure donnée à l'avance, le circuit (21) de commande ou les circuits de commande associés aux modules (12) partiels.

6. Procédé suivant l'une des revendications précédentes, **caractérisé en ce que** pour tous les interrupteurs (S1, S2) de tous les modules (12) partiels du au moins un circuit (11) série ou du montage (5) convertisseur a lieu dans l'ensemble une limitation des coupures, respectivement **en ce que** l'on ne charge pas, au-delà d'une mesure donnée à l'avance, les circuits de commande associés aux interrupteurs (S1, S2).

7. Module (22) de commande d'un circuit (21) de commande, qui est constitué pour la fermeture et l'ouverture d'interrupteurs (S1, S2) d'un module (12) partiel d'un montage (5) convertisseur, et de fait d'un montage (5) convertisseur tel qu'il a au moins un circuit (11) série ayant au moins deux modules (12) partiels montés en série, qui comprennent chacun au moins deux interrupteurs (S1, S2) et un condensateur (C), le module (22) de commande étant conformé, de manière à ce qu'il effectue une limitation des opérations de commutation du dispositif de commande, en ce que l'on ne charge pas celui-ci, au-delà d'une mesure donnée à l'avance, **caractérisé en ce que**

   le module (22) de commande est constitué de manière à ce qu'il règle, pour le circuit (21) de commande associé, respectivement une variable (KV) de contrôle, dans lequel la variable (KV) de contrôle

      - pour chaque opération de fermeture et/ou d'ouverture du ou des interrupteurs (S1, S2), est augmentée en valeur absolue d'une valeur (ZW) d'augmentation, qui est proportionnelle à la consommation d'énergie et/ou de charge du circuit (21) de commande nécessaire à la fermeture et/ou à l'ouverture de l'interrupteur (S1, S2) respectif, et
      - réduite en valeur absolue entre des opérations successives de fermeture et/ou d'ouverture, dans lequel

   la réduction s'effectue proportionnellement à la vitesse de charge à laquelle on charge un accumulateur (ES) d'énergie du circuit (21) de commande entre des opérations de commutation du ou des interrupteurs (S1, S2), et dans lequel le module (22) de commande est constitué de manière à ce qu'

      - il bloque le circuit (21) de commande et ainsi une fermeture et/ou une ouverture du ou des interrupteurs (S1, S2) associé, si la variable (KV) de contrôle dépasse une valeur (KVmax) de seuil donnée à l'avance, et
      - après un dépassement de la valeur de seuil, une validation du circuit (21) de commande, pour la fermeture et/ou l'ouverture d'un ou des plusieurs des interrupteurs (S1, ,S2) associé, soit rétablie, si la variable (KV) de contrôle redevient inférieure à la valeur (KVmax) de seuil ou redevient inférieure à une valeur de seuil plus petite que la valeur (KVmax) de seuil pour la formation d'un comportement d'hystérésis.

8. Montage (5) convertisseur, qui comprend au moins un circuit (11) série,

- dans lequel le au moins un circuit (11) série a au moins deux modules (12) partiels montés en série, qui comprennent chacun au moins deux interrupteurs (S1, S2) et un condensateur (C), et
- dans lequel, dans le montage (5) convertisseur, il s'effectue, pendant son fonctionnement, une commutation d'un ou de plusieurs des modules (12) partiels,

**caractérisé en ce que**
au moins des modules (12) partiels, de préférence tous les modules (12) partiels, est équipé respectivement d'au moins un module (22) de commande suivant la revendication 7.

FIG 1

EP 3 751 714 B1

FIG 2

EP 3 751 714 B1

# EP 3 751 714 B1

## IN DER BESCHREIBUNG AUFGEFÜHRTE DOKUMENTE

**In der Beschreibung aufgeführte Patentdokumente**

- WO 2012156261 A2

- US 2016018446 A1

**In der Beschreibung aufgeführte Nicht-Patentliteratur**

- **A. LESNICAR ; R. MARQUARDT.** An Innovative Modular Multilevel Converter Topology Suitable for Wide Power Range. *IEEE Bologna Power Tech Conference,* 2003